# EUROPÄISCHE PATENTSCHRIFT

(11) **EP 2 404 178 B1**
(45) Veröffentlichungstag und Bekanntmachung des Hinweises auf die Patenterteilung: **26.09.2012**
(21) Anmeldenummer: 10702590.0
(22) Anmeldetag: 12.01.2010
(51) Int. Cl.: G01R 31/14

(54) **VORRICHTUNG FÜR SYSTEMKOMPONENTEN EINES HOCHSPANNUNGS-IMPULSPRÜFSYSTEMS**
DEVICE FOR A SYSTEM COMPONENTS OF A HIGH-VOLTAGE IMPULSE TEST SYSTEM
DISPOSITIF POUR COMPOSANTS D'UN SYSTÈME DE TEST D'IMPULSIONS HAUTE TENSION

(30) Priorität: 06.03.2009 DE 102009012113
(43) Veröffentlichungstag der Anmeldung: 11.01.2012
(73) Patentinhaber: Maschinenfabrik Reinhausen GmbH, 93059 Regensburg (DE)
(72) Erfinder: HINOW, Martin, 01307 Dresden (DE); KUBAT, Marti, 01309 Dresden (DE); STEINER, Thomas, 01445 Radebeul (DE)
(86) Internationale Anmeldenummer: PCT/EP2010/000097
(87) Internationale Veröffentlichungsnummer: WO 2010/099843

(56) Entgegenhaltungen:
- DE-A1- 2 801 561
- "IMPULSE VOLTAGE TEST SYSTEM SGSA 100-800 kV, 5-40 kJ" HAEFELY HIGH VOPLTAGE TEST, Nr. E113.12, Februar 2001 (2001-02), Seiten 1-19, XP009109093
- Anonymous: "Low-Damped Capacitive Impulse Voltage Dividers / Basic Load Capacitors, Type SMC 100kV - 6000kV" HIGHVOLT Prüftechnik Dresden GmbH - Data sheet no. 3.61/2 Juni 2004 (2004-06), Seiten 1-4, XP002581006 Gefunden im Internet: URL:http://www.highvolt.de/datasheets/3-61 -2.pdf [gefunden am 2010-05-03]

## Beschreibung

Die vorliegende Erfindung betrifft eine Vorrichtung für Systemkomponenten eines Hochspannungs-Impulsprüfsystems, vorzugsweise zur Qualitätssicherung von Leistungstransformatoren.

Die Hochspannungsprüfung verfolgt den Zweck, transiente Überspannungen in Drehstromnetzen mittels künstlich erzeugten impulsförmigen Stößen zu simulieren. Dabei wird klassischerweise zwischen äußeren Überspannungen, die beispielweise durch einen Blitzschlag hervorgerufen werden, und inneren Schaltungsüberspannungen, die auf Grund von Schaltvorgängen im Netz entstehen, unterschieden. Die Vielzahl der Überspannungserscheinungen werden für Prüfzwecke auf genormte Blitz- und Schaltungsstoßspannungen reduziert. Für diese Prüfspannungen werden Kenngrößen festgelegt, die den Anstieg der Spannung, den Scheitelwert und den Rückabfall innerhalb bestimmter Toleranzen beschreiben. Bei der abgeschnittenen Blitzstoßspannung, die die Wirkung sehr schneller Spannungsänderungen simulieren soll, kommt als weitere Kenngröße die Abschneidezeit hinzu. Die Anforderungen, Spannungsformen sowie die Bestimmung derer Parameter sind in der ICE 60060-1 definiert. Je nach durchgeführter Normprüfung umfasst das Hochspannungs-Impulsprüfsystem dafür einen Impulsgenerator und Hilfskomponenten wie eine Abschneidefunkenstrecke, einen Spannungsteiler und eine Overshoot-Kompensation.

Zur Erzeugung der erforderlichen impulsförmigen Stoßspannungen haben sich im Laufe der Jahre besonders Marx'sche Vervielfachungsschaltungen, auch Marx-Generatoren genannt, auf dem Markt etabliert. Der von dem gleichnamigen Erfinder 1923 entwickelte und unter der Nummer DE 455 933 zum Patent erteilte Schaltungstyp ist in mehreren Schaltungsstufen aufgebaut, wobei jede der Stufen in Serie geschaltet eine Stoßkapazität und ein Schaltorgan, insbesondere eine Schaltfunkenstrecke, und zu der Stoßkapazität und dem Schaltorgan parallelgeschaltet einen Widerstand sowie hierzu in Serie geschaltet einen Widerstand aufweist. Dabei sind zwei aufeinanderfolgende Stufen derart miteinander verbunden, dass sie parallelgeschaltet aufladbar und in Serie geschaltet entladbar sind.

Die Stoßkondensatoren werden mittels einer Ladegleichspannung aufgeladen. Eingeschleifte Ladewiderstände begrenzen hierbei nicht nur den Ladestrom, sondern erlauben auch eine kurzzeitige Reihenschaltung der Kondensatoren mittels der Funkenstrecken. Die Schlagweiten der Funkenstrecken sind so gewählt, dass diese bei Erreichen der maximalen Ladespannung gerade noch nicht durchschlagen.

Nachdem alle Stoßkondensatoren auf ihren quasistationären Endwert der Spannung aufgeladen sind, erfolgt die Zündung der untersten Funkenstrecke, die daraufhin durchschlägt. An der nächsten Funkenstrecke steht nunmehr die doppelte Ladespannung an, so dass diese mit Sicherheit zünden wird. Unabhängig von der Anzahl der verbauten Stufen setzt sich der Entladungsvorgang auf Grund der Addition der Ladespannungen vorherig gezündeter Stufen bis zur letzten Stufe fort.

Auf diese Weise sind Stoßspannungsimpulse sehr kurzer Zeitdauer und gleichzeitig großer Amplitude erzeugbar, die sich insbesondere für Prüfzwecke und Versuche in der Hochspannungstechnik und zum Nachweis der Isolationskoordination und Störfestigkeit in der elektromagnetischen Verträglichkeit eignen.

Auch ist es beispielsweise aus der DE 196 39 023 bekannt, die Grenzbelastungskapazität des eben beschriebenen Marx-Generators mittels eines Schaltungszusatzes zu erhöhen, indem man während des Überschwingens an der Belastungskapazität, d. h. am Prüfling, eine Spannungsverringerung erreicht, die nach dem Abklingen des Überschwingens wieder aufgehoben wird. Der Schaltungszusatz, auch als serielle Overshoot-Kompensation bezeichnet, reduziert damit nicht die Ursache des Überschwingens, sondern kompensiert das Überschwingen an der Belastungskapazität, d. h. insbesondere am Prüfling. Die Overshoot-Kompensation besteht aus einer Kompensationskapazität und zumindest einem zu dieser parallelgeschalten Entladungswiderstand oder einer Entladungsfunkenstrecke, wobei der Schaltungszusatz in serieller Bauweise zu dem Prüfobjekt in die Marx'sche Vervielfachungsschaltungen einzuschleifen ist. Neben der zum Prüfobjekt seriell geschalteten Overshoot-Kompensation ist es auch bekannt, diese in parallel geschalteter Bauform zum Prüfling auszugestalten. Anders als bei der eben beschriebenen Bauform sind bei einer derart ausgebildeten Overshoot-Kompensation die Kompensationskapazität und der zumindest eine Entladungswiderstand oder Entladungsfunkenstrecke seriell angeordnet.

Weiterhin ist es für die Nachbildung einer betriebsmäßigen Überspannungsbeanspruchung und zum Nachweis der Isolationsfestigkeit von Hochspannungsbauteilen auch erforderlich, die Prüfobjekte wie bereits erwähnt mit einer abgeschnittenen Stoßimpulsspannung zu beaufschlagen. Für einen erfolgreichen Verlauf einer derartigen Normprüfung ist es notwendig, dass die angelegte Spannung innerhalb einer Toleranz von wenigen Mikrosekunden der gewünschten seit Beginn der Spannungswelle verflossenen Zeit unterbrochen wird. Technisch realisiert wird dies mit Abschneide-Funkenstrecken, wie sie bereits seit Langem aus dem Stand der Technik, z. B. aus der DD 143 130, bekannt geworden sind.

Zudem wird in einem Hochspannungs-Impulsprüfsystem an die letzte Stufe der Marx'schen Vervielfachungsschaltung neben dem Prüfobjekt auch ein kapazitiv gedämpfter Impulsspannungsteiler angeschlossen, der die beim Entladen der Stufen erzeugte Blitzimpulsspannung auf Werte reduziert, die von den Mess- und Aufzeichnungsgeräten verarbeitet werden können.

All diese verbauten Systemkomponenten des Hochspannungs-Impulsprüfsystems haben eine beachtliche räumliche Ausdehnung und müssen in einem vorgegebenen, vom Spannungspegel abhängigen Mindestabstand zueinander im Prüffeld angeordnet werden. Darüberhinaus müssen ebenfalls definierte spannungsabhängige Mindestabstände zwischen spannungstragenden Elementen und der Prüffeldbegrenzung eingehalten werden. Der Platzbedarf des gesamten Hochspannungs-Impulsprüfsystems ist damit erheblich. Weiterhin muss bei vielen Transformatorenherstellem zum Wechseln des Prüfobjekts das gesamte Hochspannungs-Impulsprüfsystem verschoben werden. In diesem Fall müssen der Marx-Generator und die drei weiteren Hilfskomponenten einzeln durch die Prüfhalle bewegt und als Hochspannungs-Impulsprüfsystem wieder neu zusammengebaut und eingerichtet werden. Dieser Vorgang ist zeitaufwändig und in der Handhabung umständlich.

Aufgabe der vorliegenden Erfindung ist es, die spannungsbedingte räumliche Ausdehnung der Hilfskomponenten, insbesondere der Abschneide-Funkenstrecke, der Overshoot-Kompensation und des Spannungsteilers, zu reduzieren und damit den Platzbedarf des gesamten Hochspannungs-Impulsprüfsystems zu verringern, um die Prüfhalle effizienter betreiben zu können. Weiterhin ist es eine Aufgabe der Erfindung, die Anzahl der zu realisierenden galvanischen Verbindungen zu reduzieren und damit dem Anlagenbetreiber Zeit bei der Einrichtung des Hochspannungs-Impulsprüfsystems zu ersparen.

Diese Aufgabe wird durch eine Vorrichtung für Systemkomponenten eines Hochspannungs-Impulsprüfsystems mit den Merkmalen des ersten Patentanspruches gelöst. Die Unteransprüche betreffen besonders vorteilhafte Weiterbildungen der Erfindung.

Die allgemeine Idee der Erfindung besteht darin, die bisher separaten Grundrahmen und jeweiligen Kopfelektroden der einzelnen Hilfskomponenten durch einen gemeinsamen Grundrahmen mit einer für die Hilfskomponenten gemeinsamen Kopfelektrode zu ersetzen..Weiterhin soll als Anschlussbereich für alle Hilfskomponenten ein gemeinsamer galvanischer Verbindungspunkt dienen. Indem die Anschlussbereiche der Hilfskomponenten in einem gemeinsamen Verbindungspunkt zusammengeführt werden, weisen sie in diesem Bereich während der durchgeführten Prüfung das selbe Spannungsniveau auf. Daher ist für den Betrieb des Hochspannungs-Impulsprüfsystems nur mehr eine Verbindung zum Generator und eine zum Prüfobjekt notwendig. Zudem ist es durch die konstruktive Zusammenführung der Hilfskomponenten in einen gemeinsamen Grundrahmen dem Anlagenbetreiber erstmals möglich, der seit einigen Jahren bestehenden Forderung nach Hochspannungs-Impulsprüfsystemen mit wenig Platzbedarf, einfacher Transportierbarkeit und damit einhergehenden kurzen Installationszeiten nachzukommen. Die große Flächenausdehnung des Hochspannungs-Impulsprüfsystems war bisher den großen vorgegebenen spannungsabhängigen Abständen zwischen den einzelnen Kopfelektroden der jeweiligen Hilfskomponenten geschuldet. Um diese mehreren Kopfelektroden durch eine einzige Kopfelektrode an dem Grundrahmen zu ersetzen und zudem die Hilfskomponenten in dem Grundrahmen räumlich zusammenzuführen, galt es allerdings nachfolgende technische Problemstellungen erfinderisch zu lösen:
Durch das bloße räumliche Zusammenstellen der Hilfskomponenten entstehen zusätzliche Streukapazitäten, die die Genauigkeit des Spannungsteilers negativ beeinflussen. Der Spannungsteiler muss dabei so abgestimmt werden, dass die durchgeführten Messungen trotz der großen auftretenden Streukapazitäten von hoher Genauigkeit gekennzeichnet sind. Dies wird erfindungsgemäß einerseits durch eine definierte räumliche Anordnung der Hilfskomponenten erreicht, so dass die parasitäre kapazitive Wirkung gering ist, andererseits durch eine definierte Bestimmung der Kapazitäten innerhalb der verwendeten Hilfskomponenten, so dass die resultierende Gesamtkapazität ein genaues Messen zulässt, und zudem durch geeignete Wahl der Teiler-Kapazität und des Teiler-Widerstandes. Auf Grund der fehlenden linearen Zusammenhänge der eben genannten Einstellmöglichkeiten finden sich in der Literatur zur Bestimmung dieser Parameter allerdings nur Näherungsmodelle, was dazu führt, dass die Größe der parasitären Kapazitäten durch Simulationen abgeschätzt werden müssen. Diese Simulationen sind anschließend in Entwicklungsversuchen zu verifizieren; das Ganze ist somit ein iterativer Prozess.

Weiterhin sind durch die räumliche Zusammenführung der Hilfskomponenten die entstehenden elektromagnetischen Felder abzustreuen, um auftretende Spannungsüberschläge wirkungsvoll zu verhindern. Speziell das Durchzünden der Abschneide-Funkenstrecke ist mit einem komplizierten transienten Vorgang verbunden. Dabei trägt die Abschneide-Funkenstrecke für kurze Zeit ein Nullpotential, während die übrigen Hilfskomponenten, bedingt durch ihre eigenen Kapazitäten, noch mit hohen Spannungen beaufschlagt sind. Die Feldsteuerung muss daher dahingehend optimiert werden, einen Spannungsüberschlag zwischen dem Spannungsteiler und der Abschneide-Funkenstrecke, bzw. der Overshoot-Kompensation und der Abschneide-Funkenstrecke zu verhindern, wofür eine umfangreiche Feldberechnung notwendig ist. Da sich mit den meisten Feldberechnungsprogrammen jedoch nur der stationäre, nicht aber der transiente Fall sich stark veränderlicher Felder berechnen lässt, ist auch hierfür ein iterativer Prozess zwischen Simulation und konstruktiver Umsetzung von Nöten. Als vorteilhaft hat es sich hierbei erwiesen, die Overshoot-Kompensation und den Spannungsteiler mit zusätzlichen Toroiden gegenseitig elektrisch abzuschirmen.

Zwar ist es aus der Firmenschrift 3.62/4 der Anmelderin erstmals bekannt geworden, eine Abschneide-Funkenstrecke mit einem Spannungsteiler für Blitzstoßschaltimpulse zu integrieren, nur können in dieser Vorrichtung die beiden Hilfskomponenten nicht wie in der vorliegenden Erfindung zeitgleich genutzt werden. Aus dem Stand der Technik bekannte Abschneide-Funkenstrecke weisen üblicherweise unter anderem eine Säule, bestehend aus einer Kombination von Widerständen und Kapazitäten, auf und besitzen damit die gleichen Bauteile wie kapazitiv-gedämpfte Spannungsteiler. Wenn die Funkenstrecke nicht durchzündet ist es dadurch möglich, die Säule der Abschneide-Funkenstrecke als Spannungsteiler umzufunktionieren. Das heißt aber im Umkehrschluss auch, dass ein zusätzlicher Spannungsteiler bei der Prüfung vorhanden sein muss, wenn die Spannungswelle abgeschnitten wird, also die Funkenstrecke durchzündet. Eine Lösung zur räumlichen Zusammenführen der Hilfskomponenten ist dieser Firmenschrift nicht zu entnehmen.

Darüber hinaus ist es im Rahmen der Erfindung durchaus auch denkbar, nur zwei der möglichen drei Hilfskomponenten in dem gemeinsamen Grundrahmen räumlich zusammenzuführen, da beispielsweise der Einsatz der Overshoot-Kompensation nicht als zwingend funktionsnotwendig anzusehen ist, sondern nur die Qualität der erzeugten Blitzstoßspannung erhöht. Auch eine andere Kombinationsmöglichkeit der Hilfskomponenten ist denkbar.

Die Vorrichtung soll nachstehend beispielhaft an Hand von Zeichnungen noch näher erläutert werden.

Es zeigen:
- Figur 1: eine schematische Darstellung einer erfindungsgemäßen Vorrichtung für Systemkomponenten eines Hochspannungs-Impulsprüfsystems
- Figuren 2a und 2b: bevorzugte Ausführungsform einer erfindungsgemäßen Vorrichtung für Systemkomponenten eines Hochspannungs-Impulsprüfsystems.

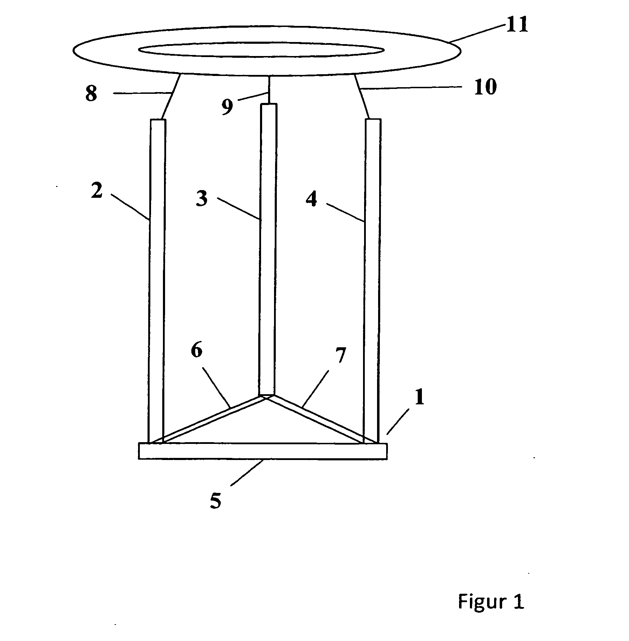

In Figur 1 ist ein erfindungsgemäßer Grundrahmen 1 zur Aufnahme von Hilfskomponenten, wie einer Abschneide-Funkenstrecke 2, eines Spannungsteilers 3 oder einer Overshoot-Kompensation 4, abgebildet. Die Hilfskomponenten finden sich in Figur 1 aus Gründen der Übersichtlichkeit nur schematisch dargestellt wieder. Der Grundrahmen 1 weist dabei für einen sicheren Stand einen beispielsweise dreiecksförmigen Bodenbereich aus miteinander verbundenen Stahlrohren 5, 6 und 7 auf. Die Abschneide-Funkenstrecke 2, der Spannungsteiler 3 und die Overshoot-Kompensation 4 sind an den jeweiligen Eckpunkten des Grundrahmens 1 angeordnet und mit diesem leitend verbunden. Zudem sind die oberen Enden der entsprechenden Hilfskomponenten mittels elektrisch leitenden Querstreben 8, 9 und 10 mechanisch fixiert. Wederum mit den Querstreben 8, 9 und 10 verbunden ist eine Kopfelektrode 11, die beispielsweise als Toroid ausgebildet sein kann. Die leitenden Querstreben 8, 9 und 10 erfüllen somit sowohl die Aufgabe, die Kopfelektrode 11 mechanisch zu haltern, als auch einen Potentialausgleich zwischen den Hilfskomponenten und der Kopfelektrode 11 zu schaffen. Die Kopfelektrode 11 ist in dem abgebildeten Ausführungsbeispiel derart dimensioniert, dass der äußere Umfang über die an den jeweiligen Eckpunkten angeordneten Hilfskomponenten ragt. Diese Dimensionierung kann allerdings, abhängig vom jeweiligen Anwendungsfall, dem Abstand zur Laborwand bzw. Labordecke oder dem Spannungspegel, variieren und ist daher nur beispielhaft zu werten. Es ist im Rahmen der Erfindung durchaus denkbar, nur zwei der möglichen drei Hilfskomponenten an den jeweiligen Eckpunkten des dreiecksförmigen Bodenbereichs zu befestigen, oder andererseits den erfindungsgemäßen Grundrahmen 1 mit nur zwei Aufnahmen für Hilfskomponenten konstruktiv abzuwandeln. Zudem sind die Hilfskomponenten über einen gemeinsamen Verbindungspunkt im Bereich der leitenden Querstreben 8, 9 und 10 untereinander galvanisch verbunden und weisen damit in diesem Bereich das gleiche Spannungsniveau auf.

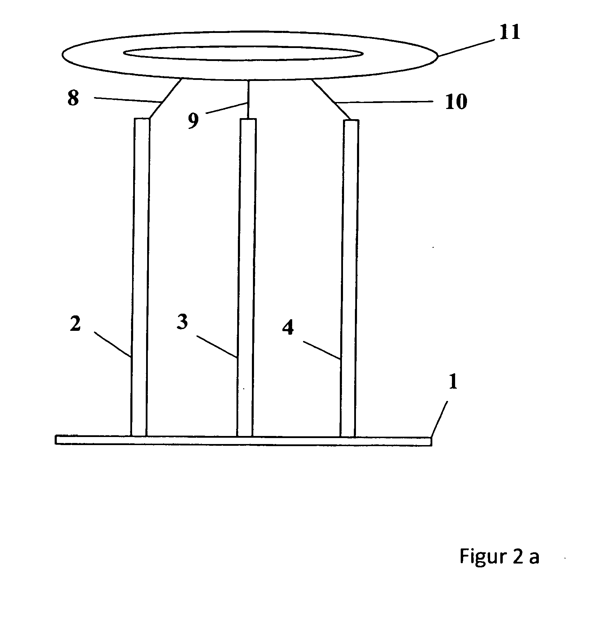

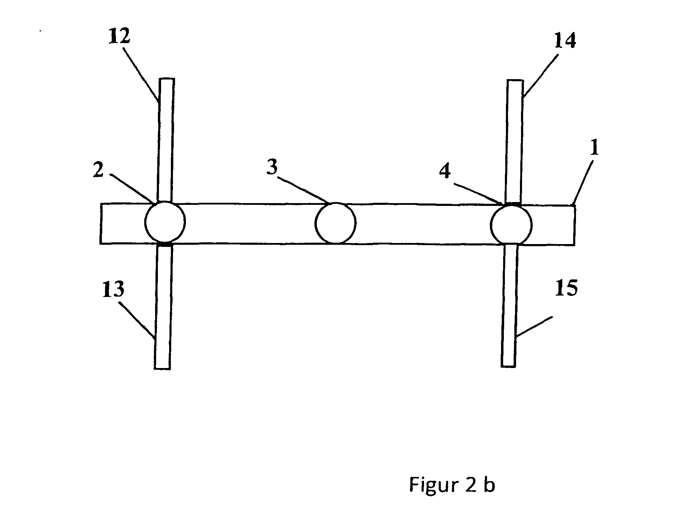

Die Figuren 2a und 2b zeigen eine bevorzugte Ausführungsform der Erfindung, bei der der Bodenbereich des Grundrahmens 1 abweichend zu Figur 1 nicht dreiecksförmig, sondern sich längs ersteckend, also linear aufgebaut ist. Zusätzliche, seitlich an dem Grundrahmen 1 befestigte, Ausleger 12, 13, 14 und 15 sorgen für einen sicheren Stand der abgewandelten Rahmenkonstruktion. Auch für diese Ausführungsform gilt, dass sie durchaus nur mit Aufnahmen für zwei Hilfskomponenten ausgebildet sein kann.

Damit sind alle Grundrahmenausgestaltungen der allgemeinen erfinderischen Idee dieser Anmeldung zuzuordnen, die es ermöglichen, die bisher separaten Grundrahmen und jeweiligen Kopfelektroden der einzelnen Hilfskomponenten durch einen gemeinsamen Grundrahmen mit einer für die Hilfskomponenten gemeinsamen Kopfelektrode zu ersetzen.

## Patentansprüche

1. Vorrichtung für Systemkomponenten eines Hochspannungs-Impulsprüfsystems,
umfassend einen Impulsgenerator und Hilfskomponenten, nämlich eine Abschneide-Funkenstrecke (2), einen Spannungsteiler (3) und eine Overshoot-Kompensation (4),
**dadurch gekennzeichnet,**
**dass** wenigstens zwei der Hilfskomponenten an einem gemeinsamen Grundrahmen (1) mit einer für die Hilfskomponenten einzigen Kopfelektrode (14) angeordnet sind.

2. Vorrichtung nach Anspruch 1,
**dadurch gekennzeichnet,**
**dass** der Grundrahmen (1) aus einem Bodenbereich von dreiecksförmigen miteinander verbundenen Stahlrohren (5, 6 und 7) gebildet wird,
**dass** an den jeweiligen Eckpunkten des Bodenbereiches des Grundrahmens (1) Aufnahmen für die Hilfskomponenten vorgesehen sind,
und **dass** die oberen Enden der entsprechenden Hilfskomponenten mittels elektrisch leitenden Querstreben (8, 9 und 10) mechanisch fixiert werden, derart, dass damit sowohl eine mechanische Verbindung, als auch ein Potentialausgleich zwischen den Hilfskomponenten und der Kopfelektrode (14) geschaffen wird.

3. Vorrichtung nach Anspruch 1,
**dadurch gekennzeichnet,**
**dass** der Bodenbereich des Grundrahmens (1) linear ausgebildet ist,
**dass** seitlich an dem Grundrahmen (1) mehrere Ausleger (12, 13, 14 und 15) befestigt sind,
**dass** der lineare Grundrahmen wenigstens zwei Aufnahmen für die Hilfskomponenten aufweist,
und **dass** die oberen Enden der entsprechenden Hilfskomponenten mittels elektrisch leitenden Querstreben (8, 9 und 10) mechanisch fixiert werden, derart, dass damit sowohl eine mechanische Verbindung, als auch ein Potentialausgleich zwischen den Hilfskomponenten und der Kopfelektrode (14) geschaffen wird.

4. Vorrichtung nach einem der Ansprüche 1 oder 2,
**dadurch gekennzeichnet,**
**dass** die einzige Kopfelektrode (14) an den leitenden Querstreben (11, 12 und 13) befestigt ist.

5. Vorrichtung nach einem der Ansprüche 1 bis 3,
**dadurch gekennzeichnet,**
**dass** die Kopfelektrode (14) als Toroid ausgebildet ist.

6. Vorrichtung nach einem der Ansprüche 1 bis 3,
**dadurch gekennzeichnet,**
**dass** als elektrische Anschlussschnittstelle für alle Hilfskomponenten ein gemeinsamer Verbindungspunkt im Bereich der leitenden Querstreben (11, 12 und 13) vorgesehen ist.

## Claims

1. Device for system components of a high-voltage pulse test system, comprising a pulse generator and auxiliary components, namely a cut-off spark gap (2), a voltage divider (3) and an overshoot compensation (4), **characterised in that** at least two of the auxiliary components are arranged a common base frame (1) with a single head electrode for the auxiliary components.

2. Device according to claim 1, **characterised in that** the base frame (1) is formed by a base region of triangularly interconnected steel tubes (5, 6 and 7), that mounts for the auxiliary components are provided at the respective corner points of the base region of the base frame (1) and that the upper ends of the corresponding auxiliary components are mechanically fixed by means of electrically conductive transverse struts (8, 9 and 10) in such a manner that not only a mechanical connection, but also an equalisation of potential between the auxiliary components and the head electrode (14) is created by that.

3. Device according to claim 1, **characterised in that** the base region of the base frame (1) is of linear construction, that several arms (12, 13, 14 and 15) are laterally fastened to the base frame (1), that the linear base frame has at least two mounts for the auxiliary components and that the upper ends of the corresponding auxiliary components are mechanically fixed by means of electrically conductive transverse struts (8, 9 and 10) in such a manner that not only a mechanical connection, but also an equalisation of potential between the auxiliary components and the head electrode (14) is created by that.

4. Device according to one of claims 1 and 2, **characterised in that** the single head electrode (14) is fastened to the conductive transverse struts (11, 12 and 13).

5. Device according to any one of claims 1 to 3, **characterised in that** the head electrode (14) is constructed as a toroid.

6. Device according to any one of claims 1 to 3, **characterised in that** a common connecting point is provided in the region of the conductive transverse struts (11, 12 and 13) as electrical connection interface for all auxiliary components.

## Revendications

1. Dispositif pour des composants de système d'un système de contrôle d'impulsions haute tension comprenant un générateur d'impulsions et des composants auxiliaires, à savoir un élément de décharge et de coupure (2), un diviseur de tension (3) et un élément de compensation sur-oscillations (4),
**caractérisé en ce qu'**
au moins deux de ces composants auxiliaires sont montés sur un châssis principal commun (1) équipé d'une électrode de tête unique (14) pour les composants auxiliaires.

2. Dispositif conforme à la revendication 1,
**caractérisé en ce que**
- le châssis principal (1) est formé d'une zone de base constituée par des tubes d'acier (5, 6 et 7) reliés les uns aux autres de façon à former un triangle
- chacun des sommets de la zone de base du châssis principal (1) est équipé de moyens de réception des composants auxiliaires, et
- les extrémités supérieures des composants auxiliaires sont fixées mécaniquement au moyen d'entretoises transversales (8, 9 et 10) électriquement conductrices, de sorte que l'on obtienne ainsi une liaison mécanique et également un équilibrage de la tension entre les composants auxiliaires et l'électrode de tête (14).

3. Dispositif conforme à la revendication 1,
**caractérisé en ce que**
- la zone de base du châssis principal (1) est horizontale,
- plusieurs bras (12, 13, 14 et 15) sont fixés latéralement sur le châssis principal (1),
- le châssis principal horizontal est équipé d'au moins deux moyens de réception des composants auxiliaires, et
- les extrémités supérieures des composants auxiliaires sont fixés mécaniquement au moyen d'entretoises transversales (8, 9 et 10) électriquement conductrices de façon à obtenir ainsi une liaison mécanique et également un équilibrage de la tension entre les composants auxiliaires et l'électrode de tête (14).

4. Dispositif conforme à l'une des revendications 1 et 2,
**caractérisé en ce que**
l'électrode de tête unique (14) est fixée aux entretoises transversales conductrices (11, 12 et 13).

5. Dispositif conforme à l'une des revendications 1 et 3,
**caractérisé en ce que**
l'électrode de tête (14) est réalisée sous la forme d'un toroïde.

6. Dispositif conforme à l'une des revendications 1 et 3,
**caractérisé en ce que**
il est prévu, en tant qu'interface de connexion de tous les composants auxiliaires un point de liaison commun dans la zone des entretoises transversales conductrices (11, 12 et 13).
